# EUROPÄISCHE PATENTSCHRIFT

(11) **EP 3 482 416 B1**
(45) Veröffentlichungstag und Bekanntmachung des Hinweises auf die Patenterteilung: **22.04.2020**
(21) Anmeldenummer: 17742389.4
(22) Anmeldetag: 10.07.2017
(51) Int. Cl.: H01L 51/00

(54) **VERFAHREN UND AUSHÄRTBARE MASSE ZUM VERGIESSEN ELEKTRONISCHER BAUTEILE ODER BAUTEILGRUPPEN**
METHOD AND CURABLE COMPOUND FOR CASTING ELECTRONIC COMPONENTS OR COMPONENT GROUPS
PROCÉDÉ ET MATIÈRE DURCISSABLE POUR SCELLER DES COMPOSANTS ÉLECTRONIQUES OU DES GROUPES DE COMPOSANTS

(30) Priorität: 11.07.2016 DE 102016112655; 23.02.2017 DE 102017202956
(43) Veröffentlichungstag der Anmeldung: 15.05.2019
(73) Patentinhaber: Robert Bosch GmbH, 70442 Stuttgart (DE)
(72) Erfinder: REIL, Arno, 64686 Lautertal (DE); WIESER, Jürgen, 64372 Ober-Ramstadt (DE); SPENGLER, Jan, 64711 Erbach (DE); KLEIN, Roland, 64372 Ober-Ramstadt (DE); KREICKENBAUM, Alexandra, 64380 Roßdorf (DE)
(86) Internationale Anmeldenummer: PCT/EP2017/067210
(87) Internationale Veröffentlichungsnummer: WO 2018/011116

(56) Entgegenhaltungen:
- JP-A- H0 951 009
- JP-A- H05 267 507
- JP-A- 2001 223 305

## Beschreibung

### Technisches Anwendungsgebiet

Die vorliegende Erfindung betrifft ein Verfahren zum Vergießen elektronischer Bauteile oder Bauteilgruppen, bei dem die Bauteile oder die Bauteilgruppe in eine Vergussmasse eingebettet und die Vergussmasse über wenigstens einen Vernetzungsprozess anschließend ausgehärtet wird. Die Erfindung betrifft auch eine aushärtbare Masse, die als Vergussmasse für das Verfahren einsetzbar ist

Das Vergießen von elektronischen Bauteilen stellt einen wichtigen Bestandteil bei der Fertigung moderner Elektroniksysteme dar. Die Wahl der richtigen Vergussmasse erfordert derzeit allerdings eine Entscheidung darüber, ob eine weichere oder eine steifere Vergussmasse für das Vergießen der Bauteile eingesetzt werden muss.

Weiche Vergussmassen sind in der Lage, Spannungen auszugleichen, die beispielsweise durch den Schrumpf während der Aushärtung oder aufgrund von stark unterschiedlichen Wärmeausdehnungskoeffizienten bei Temperaturwechseln entstehen. Sie bieten jedoch häufig keinen ausreichenden Schutz gegenüber äußeren mechanischen oder chemischen Belastungen. Der Schutz des Bauteils gegenüber solchen Belastungen muss dann durch ein separates Gehäuse geschaffen werden. Steife Vergussmassen bieten zwar einen guten Schutz der Elektronik gegenüber Chemikalien und mechanischen Belastungen, sind aber für eine Spannungsreduktion weniger geeignet als weiche Materialien. In vergossenen Elektronikbauteilen kommt es bei Temperaturschwankungen aufgrund der meist sehr unterschiedlichen thermischen Ausdehnungskoeffizienten von Bauteil und Vergussmasse zum Aufbau von mechanischen Spannungen, die bei Verwendung einer steifen Vergussmasse das elektrische Bauteil schädigen können. Außerdem ist der Reaktionsschrumpf steifer Vergussmassen meist stärker ausgeprägt. Dies kann im ungünstigsten Fall zum Ablösen von elektronischen Komponenten von der Platine führen.

### Stand der Technik

Im Bereich der Elektronik sollte eine Vergussmasse mehrere Funktionen erfüllen. Sie sollte die elektronischen Bauteile vollständig umhüllen und gegen Eindringen von Feuchtigkeit, Staub, Fremdkörpern, Wasser, Chemikalien u.a. schützen, insbesondere einen wirksamen Korrosionsschutz für die elektronischen Bauteile bieten. Die Umhüllung sollte auch eine elektrische Isolation der elektronischen Bauteile zur Erhöhung von Spannungsfestigkeit und Berührungsschutz sicherstellen. Die Vergussmasse sollte eine Fixierung der Bauteile untereinander bewirken und die mechanische Stabilität sowie die Vibrations- und Schockfestigkeit der vergossenen elektronischen Bauteile erhöhen. Weiterhin sollten durch die Vergussmasse Hohlräume verfüllt und die Wärmeabfuhr aus den elektronischen Bauteilen verbessert werden.

Bei bekannten Vergussmassen in der Elektronikindustrie handelt es sich überwiegend um reaktive Harzformulierungen. Es gibt 1-K- und 2-K-Systeme, die in der Regel eine gute Fließfähigkeit (niedrige Viskosität) besitzen, um das zu vergießende Bauteil blasenfrei umschließen zu können. Kommerziell verfügbare Vergussmassen werden z.B. auf Basis von Polyurethanen, Acrylaten, ungesättigten Polyesterharzen, Epoxidharzen oder Silikonen hergestellt. Typischerweise werden diese Harzsysteme über radikalische Mechanismen oder Polyadditionen ausgehärtet. Dadurch gibt es am Markt eine kaum überschaubare Vielfalt unterschiedlicher Typen, die auf ihren jeweiligen Einsatzzweck hin optimiert sind. Alle bisher bekannten Vergussmassen führen unabhängig von den verwendeten Reaktivharzen oder Füllstoffen zu einem einheitlich vernetzten Verguss mit homogenen Eigenschaften wie Steifigkeit, Schwindung, Ausdehnungsverhalten usw. Neben kalt und thermisch härtenden Typen sind auch UV-härtende Vergussmassen erhältlich, die sich durch sehr kurze Aushärtezeiten auszeichnen.

Beim Vergießen elektronischer Bauteile oder Bauteilgruppen mit den bekannten Vergussmassen muss jedoch jeweils ein Kompromiss zwischen den oben bereits genannten Vor- und Nachteilen von härteren und weicheren Vergussmassen gefunden werden. Hierbei besteht das Problem, dass eine eng vernetzte, steife und harte Vergussmasse einerseits einen guten mechanischen Schutz bietet und eine hohe Chemikalienbeständigkeit aufweist, das engmaschige Netzwerk aber andererseits mit einer hohen Verarbeitungsschwindung verbunden ist, die zusammen mit der hohen Steifigkeit zu hohen mechanischen Eigenspannungen führt. Dadurch entstehen hohe, unerwünschte Beanspruchungen der sensiblen, filigranen Elektronikkomponenten. Insbesondere die fein-strukturierten Kontakte auf einer Platine sind anfällig für spannungsinduzierten Bruch und erlauben daher keine Verwendung steifer Vergussmassen. Alternativ können teilweise elastomerartige, weiche Vergussmassen eingesetzt werden, die geringere Schwindung und geringere Steifigkeit aufweisen und dadurch die entstehenden Spannungen bei der Aushärtung oder bei Temperaturwechselbeanspruchungen klein halten. Diese bieten aber häufig keinen zufriedenstellenden mechanischen Schutz und können von chemischen Medien gequollen und durchdrungen werden. In wenigen Ausnahmefällen werden mehrere unterschiedliche Vergussmassen kombiniert eingesetzt und in Schichten übereinander vergossen, was jedoch zu erhöhten Produktionsrisiken und hohem Aufwand insbesondere auch bei der Qualitätssicherung führt.

Sowohl weiche als auch harte Vergussmassen werden in der Regel beim Vergießen elektronischer Bauteile oder Bauteilgruppen so eingesetzt, dass zusätzlich ein separates Metall- oder Kunststoffgehäuse die vergossene Elektronik umgibt. Dieses Gehäuse dient oft gleichzeitig als eine Art Gussform, welche mit der Vergussmasse ausgegossen wird. Auf diese Weise kann die Elektronik zum Beispiel von einer weich aushärtenden Vergussmasse vor mechanischen Schwingungen usw. geschützt werden, während das abgedichtete Gehäuse das gesamte Bauteil vor äußeren mechanischen Einflüssen oder chemischen Angriffen schützt. Dies ist bei der Fertigung allerdings mit entsprechendem Aufwand verbunden, kostenintensiv und benötigt naturgemäß erheblich mehr Bauraum als die Elektronikkomponente an sich.

Die JP H05 267507 A offenbart ein Verfahren zum Vergießen elektronischer Bauteile, bei dem das Bauteil in eine Vergussmasse eingebettet wird, die zu zwei unterschiedlichen Netzwerken aushärtbar ist. Die Vergussmasse wird dabei nach dem Vergießen des Bauteils zunächst nur im äußeren Bereich mittels UV-Strahlung zum ersten Netzwerk und anschließend vollständig mittels Wärmebehandlung zum zweiten Netzwerk ausgehärtet, das eine geringere Härte aufweist als das erste Netzwerk.

Die Aufgabe der vorliegenden Erfindung besteht darin, ein Verfahren und eine aushärtbare Masse zum Vergießen elektronischer Bauteile oder Bauteilgruppen anzugeben, mit denen die obigen Nachteile beim Einsatz weicher oder harter Vergussmassen im Wesentlichen vermieden werden. Das Verfahren soll dabei auch ein Vergießen ohne externes Gehäuse für das vergossene Bauteil oder die vergossene Bauteilgruppe ermöglichen.

### Darstellung der Erfindung

Die Aufgabe wird mit dem Verfahren und der aushärtbaren Masse gemäß Patenanspruch 1 und 7 gelöst. Vorteilhafte Ausgestaltungen des Verfahrens und der aushärtbaren Masse sind Gegenstand der abhängigen Patentansprüche oder lassen sich der nachfolgenden Beschreibung sowie den Ausführungsbeispielen entnehmen.

Dass Verfahren ermöglicht damit das Vergießen der Bauteile ohne die bei Nutzung weicher oder steifer Vergussmassen auftretenden Probleme. Im Kontaktbereich mit dem Bauteil oder der Bauteilgruppe wird durch die geringere Netzwerkdichte ein weicher Bereich der Vergussmasse erzeugt, durch den mechanische Spannungen vermieden werden können, die beispielsweise aus dem unterschiedlichen Wärmeleitungsverhalten oder aus dem Reaktionsschrumpf der Vergussmasse resultieren. Dies führt zu mechanisch weniger belasteten und damit zuverlässigeren Bauteilen oder Bauteilgruppen. Gleichzeitig wird in dem ersten Bereich mit der höheren Netzwerkdichte eine höhere Steifigkeit erreicht, durch die eine entsprechende Schutzfunktion für das vergossene Bauteil oder die vergossene Bauteilgruppe ausgeübt werden kann. Dieser erste Bereich kann die Funktion eines Gehäuses übernehmen, so dass in einer vorteilhaften Ausgestaltung des Verfahrens der bisher erforderliche Arbeitsschritt einer zusätzlichen Gehäusung durch den entsprechenden Vernetzungsschritt der Vergussmasse im ersten Bereich eingespart werden kann. Durch den damit möglichen Verzicht auf ein externes Gehäuse kann die gesamte Komponente mit dem vergossenen elektronischen Bauteil bzw. der vergossenen elektronischen Bauteilgruppe kompakter gestaltet und damit eine Steigerung der Integrationsdichte erreicht werden. Das vorgeschlagene Verfahren ermöglicht somit das Generieren einer Gehäusefunktion aus der Vergussmasse heraus, während das Innere der Vergussmasse weich bleibt. Damit muss kein Kompromiss mehr durch die Wahl einer weicheren oder einer steiferen Vergussmasse eingegangen werden. Das Verfahren setzt nach wie vor nur eine einzige Vergussmasse ein, die mittels Kombination verschiedener Aushärtemechanismen zu unterschiedlichen Netzwerken und damit zu lokal unterschiedlich steifen Bereichen ausgehärtet werden kann.

Die vernetzende Komponente A der Vergussmasse und die zweite Komponente B werden dabei vorteilhaft so gewählt, dass sich die zwei unterschiedlichen Netzwerke im Elastizitätsmodul um wenigstens einen Faktor 2 unterscheiden. Vorzugsweise liegt der Elastizitätsmodul des härteren bzw. steiferen Bereichs zwischen 300 und 3000 MPa, besonders bevorzugt zwischen 500 und 2000 MPa. Der Elastizitätsmodul des weicheren Bereichs liegt vorzugsweise zwischen 0,5 und 200 MPa, besonders bevorzugt zwischen 1 und 100 MPa.

Die lokal begrenzte Aushärtung der wenigstens einen vernetzenden Komponente A der Vergussmasse im ersten Bereich erfolgt vorzugsweise vollständig, so dass keine nicht vernetzten Anteile der vernetzenden Komponente A in diesem Bereich verbleiben. Dies ist jedoch nicht zwingend erforderlich. Überraschenderweise wurde gefunden, dass bei einer nur partiellen Aushärtung bzw. Vernetzung zum ersten Netzwerk die noch nicht vernetzten Anteile durch Auslösen des zweiten Ereignisses durch Reaktion mit der Komponente B in diesem Bereich das zweite Netzwerk bilden. So können durch unvollständige Vernetzung der Komponente A auch Bereiche erzeugt werden deren Netzwerkdichte zwischen der des ersten Netzwerkes und der des zweiten Netzwerkes liegt. In diesen Bereichen liegen auch die Elastizitätsmoduln zwischen denen des ersten Netzwerkes und denen des zweiten Netzwerkes.

Bei vollständiger oder partieller Vernetzung der wenigstens einen vernetzenden Komponente A im ersten Bereich verbleiben keine oder nur verminderte Anteile von Komponente A, mit denen Komponente B das zweite Netzwerk ausbilden könnte. Das führt dazu, dass Komponente B in diesen Bereichen nach Auslösen des zweiten Ereignisses unreagiert in dem ersten Netzwerk verbleibt. Überraschenderweise wurde gefunden, dass durch Zugabe einer Komponente C, die nicht mit Komponente A, aber mit Komponente B reagiert, in Bereichen, in denen Komponente A nicht oder nur im Unterschuss vorliegt, überschüssige Anteile der Komponente B durch Ausbildung eines weiteren Netzwerkes gebunden werden können. Komponente C kann darüber hinaus auch mit aus der Reaktion von Komponente A mit Komponente B geknüpften Bindungen reagieren, so dass in allen Bereichen, unabhängig davon, ob in einem Bereich eine durch das erste Ereignis ausgelöste Netzwerkbildung von Komponente A vollständig, partiell oder gar nicht stattgefunden hat, nach dem zweiten Ereignis keine unreagierten Komponenten in der ausgehärteten Masse verbleiben.

Das Vergießen des Bauteils bzw. der Bauteilgruppe kann dabei in unterschiedlicher Weise erfolgen. In einer Ausgestaltung wird das zu vergießende elektronische Bauteil oder die elektronische Bauteilgruppe in ein nach oben offenes Gehäuse eingebracht und die Vergussmasse anschließend in das Gehäuse eingefüllt, um das elektronische Bauteil oder die elektronische Bauteilgruppe mit der Vergussmasse zu vergießen. Die Aushärtung wird dann derart durchgeführt, dass die wenigstens eine vernetzende Komponente A der Vergussmasse in einem das Bauteil oder die Bauteilgruppe umschließenden unteren Bereich (zweiter Bereich) zu dem zweiten Netzwerk und in dem die obere Begrenzungsfläche der Vergussmasse beinhaltenden Bereich (erster Bereich) zumindest partiell zu dem ersten Netzwerk ausgehärtet wird. Im unteren Bereich weist die Vergussmasse damit eine geringere Netzwerkdichte auf, während der obere abschließende Bereich mit der höheren Netzwerkdichte steifer ausgebildet ist und damit als abschließender Teil des Gehäuses dienen kann.

In einer weiteren Ausgestaltung wird das gesamte Bauteil oder die gesamte Bauteilgruppe in einem den zweiten Bereich umschließenden (ersten) Bereich der Vergussmasse zum ersten Netzwerk ausgehärtet und umschließt damit das Bauteil einschließlich des weicheren (zweiten) Bereiches der Vergussmasse vollständig. Dadurch wird ein gehäuseloser Verguss ermöglicht, da der äußere steifere Bereich der Vergussmasse (erster Bereich) in diesem Fall vollständig die Funktion eines Gehäuses übernehmen kann. Diese Vorgehensweise kann auch vorteilhaft derart durchgeführt werden, dass die Vergussmasse beim Vergießen des elektronischen Bauteils oder der elektronischen Bauteilgruppe so geformt und ausgehärtet wird, dass die äußere Form der ausgehärteten Vergussmasse der Kontur des elektronischen Bauteils oder der elektronischen Bauteilgruppe angenähert ist. Damit lässt sich das elektronische Bauteil oder die elektronische Bauteilgruppe zu einer sehr kompakten Komponente vergießen. Der Verguss kann dabei jeweils mit Hilfe einer Gussform oder auch werkzeuglos erfolgen.

Eine vorteilhafte Möglichkeit zum werkzeuglosen Vergießen des Bauteils oder der Bauteilgruppe mit der Vergussmasse besteht darin, die Vergussmasse mit einem additiven Fertigungsverfahren schichtweise aufzutragen und jeweils Schicht für Schicht zum ersten bzw. zweiten Netzwerk auszuhärten. Damit lässt sich vor allem die letztgenannte Ausgestaltung des gehäuselosen Vergusses sehr einfach realisieren.

Die Aushärtemechanismen für die Vernetzung der zu vernetzenden Komponente zum ersten und zweiten Netzwerk sollten sich möglichst einfach und kostengünstig auslösen lassen. Vorzugsweise werden die zu vernetzende Komponente A sowie gegebenenfalls ein oder mehrere Zusatzstoffe in der Vergussmasse so gewählt, dass die vernetzende Komponente A durch Strahlenhärtung, beispielsweise durch UV-Strahlenhärtung, zum ersten Netzwerk vernetzt. Diese Vernetzung lässt sich damit einfach und kostengünstig durchführen. Für die Vernetzung zum zweiten Netzwerk werden die zu vernetzende Komponente A sowie gegebenenfalls ein oder mehrere Zusatzstoffe in der Vergussmasse vorzugsweise so gewählt, dass die Vernetzung zum zweiten Netzwerk mit der Technik der thermischen Härtung durchgeführt werden kann. Mit dieser Kombination aus Strahlenhärtung und thermischer Härtung lässt sich besonders einfach eine Variante des Verfahrens durchführen, bei der die wenigstens eine vernetzende Komponente A der Vergussmasse zunächst in dem wenigstens einem ersten Bereich zu dem ersten Netzwerk und anschließend in verbleibenden Bereichen zu dem zweiten Netzwerk ausgehärtet wird. Selbstverständlich lassen sich auch andere Härtungsmechanismen finden, mit denen eine derartige Vorgehensweise möglich ist. Vorzugsweise wird für die Strahlenhärtung optische Strahlung in einem Wellenlängenbereich zwischen 100 nm und 700 nm, besonders bevorzugt in einem Wellenlängenbereich zwischen 250 nm und 450 nm eingesetzt. Die Wärmebehandlung zur thermischen Härtung erfolgt bevorzugt in einem Temperaturbereich zwischen 60°C und 300°C, besonders bevorzugt zwischen 110°C und 180°C. Die Temperatur während des Aushärtens wird in einer bevorzugten Ausgestaltung bei der thermischen Härtung kontinuierlich oder stufenweise erhöht.

Die Durchführung des vorgeschlagenen Verfahrens erfordert den Einsatz einer geeignet zusammengesetzten Vergussmasse mit einstellbarer, lokal steuerbarer Steifigkeit. Die Vergussmasse muss hierzu wenigstens eine vernetzende Komponente A enthalten, die durch zwei unterschiedliche Härtungsmechanismen zu zwei unterschiedlich dichten Netzwerken aushärten kann. Für den Fachmann ist es bei Vorgabe der obigen Bedingungen ohne weiteres möglich, geeignete Vergussmassen herzustellen, die diese gewünschten Eigenschaften aufweisen.

Die erfindungsgemäß vorgeschlagene aushärtbare Masse, die für das oben beschriebene Verfahren einsetzbar ist, enthält wenigstens eine vernetzende Komponente A, die homogen in der aushärtbaren Masse verteilt ist und zu wenigstens zwei unterschiedlichen Netzwerken vernetzen kann, von denen ein erstes Netzwerk durch die mindestens eine vernetzende Komponente A alleine gebildet wird, wobei eine zumindest partielle Vernetzung zum ersten Netzwerk in mindestens einem ersten Bereich (i) der aushärtbaren Masse über ein erstes Ereignis auslösbar ist. Die aushärtbare Masse enthält auch wenigstens eine zweite Komponente B, die homogen in der aushärtbaren Masse verteilt ist und mit der die wenigstens eine vernetzende Komponente A ein zweites der wenigstens zwei unterschiedlichen Netzwerke ausbilden kann, das eine geringere Netzwerkdichte aufweist als das erste Netzwerk. Die Vernetzung zu dem zweiten Netzwerk ist dabei über ein zweites Ereignis in mindestens einem zweiten Bereich (ii) der aushärtbaren Masse auslösbar, in dem das erste Netzwerk nicht oder nur partiell ausgebildet wurde. Die aushärtbare Masse enthält auch noch wenigstens eine dritte Komponente C, die homogen in der aushärtbaren Masse verteilt ist und nach der zumindest partiellen Vernetzung zum ersten Netzwerk mit noch nicht vernetzten Anteilen der wenigstens einen zweiten Komponente B im ersten (i) und zweiten Bereich (ii) zu einem weiteren Netzwerk reagiert. Die Reaktion der dritten Komponente C mit der zweiten Komponente B wird dabei durch das zweite Ereignis ausgelöst.

In einer bevorzugten Ausgestaltung ist die dritte Komponente C so gewählt, dass sie in dem mindestens einen zweiten Bereich (ii), in dem das erste Ereignis nicht ausgelöst wurde, auch mit den aus der Reaktion der mindestens einen Komponente A mit der mindestens einen Komponente B entstehenden Vernetzungspunkten zu dem weiteren Netzwerk reagieren kann.

Vorzugsweise sind die vernetzende Komponente A, die zweite Komponente B und die dritte Komponente C so gewählt, dass sich der erste (i) und zweite Bereich (ii) nach der Aushärtung im Elastizitätsmodul um mindestens einen Faktor 2 unterscheiden.

Bei der wenigstens einen vernetzenden Komponente A handelt es sich vorzugsweise um eine Verbindung mit mindestens zwei funktionellen Gruppen, insbesondere Doppelbindungen. Besonders bevorzugt sind Verbindungen mit mindestens zwei Acrylatgruppen. Beispiele für eine derartige Komponente sind Ester der Acrylsäure oder der Methacrylsäure von höherwertigen Alkoholen wie zum Beispiel Ethylenglycoldi(meth)acrylat, Diethylenglycol-di(meth)acrylat, Triethyleneglycoldi(meth)acrylat, Tetra- und Polyethylenglycoldi(meth)acrylat, 1,3-Butandioldi(meth)acrylat, 1,4-butanedioldi(meth)-acrylat, 1,6-hexanedioldi(meth)acrylat, 1,9-Nonandioldimethacrylat, Glycerindi(meth)acrylat, Diurethandimethacrylat, Trimethylolpropantri(meth)-acrylat, Pentaerythritol tetraacrylat, Dipentaerythritolpentaacrylat, 2,2-Bis(4-methacryl-oxyphenyl)propan, 1,10-Decanediol dimethacrylat, 1,5-Pentanedioldimethacrylat, 1,4-Phenylendiacrylat, Tricyclodecandimethanol dimethacrylat, (erhältlich z.B. als SR833 von Sartomer/Arkema), Tris(2-hydroxyethyl)-isocyanurattriacrylat (erhältlich z.B. als SR368 von Sartomer/Arkema). Vorzugsweise enthält die aushärtbare Masse mindestens eine weitere Komponente D, welche durch Bestrahlung mit sichtbarem oder UV-Licht Radikale erzeugt, die in der Lage sind, die wenigstens eine vernetzende Komponente A durch radikalische Kettenreaktion zu vernetzen. Der Fachmann ist in der Lage, in Produktkatalogen z.B. der BASF unter dem Hansdelsnamen Irgacure zahlreiche auch als Photoinitiator bezeichnete derartige Komponenten aufzufinden, die diese Bedingung erfüllen. Beispiele für diese durch Bestrahlung Radikale bildende Komponente D sind Bis(2,4,6-trimethylbenzoyl)-phenylphosphinoxid, 1-Hydroxycyclohexyl-phenyl-keton, 2-Hydroxy-2-methyl-1-phenyl-1-propanon, 2-hydroxy-1-{4-[4-(2-Hydroxy-2-methyl-propionyl)-benzyl]-phenyl}-2-methylpropan-1-on, 2-Hydroxy-1-[4-(2-hydroxyethoxy)phenyl]-2-methyl-1-propanon, 2,4,6-Trimethylbenzoyldiphenylphosphinat, 2,4,6-Trimethylbenzoyldiphenylphosphinoxid, 2-Methyl-1[4-(methylthio)phenyl]-2-morpholinopropan-1-on, 2-Benzyl-2-dimethylamino-1-(4-morpholinophenyl)-butanon-1, 2-Dimethylamino-2-(4-methyl-benzyl)-1-(4-morpholin-4-yl-phenyl)-butan-1-on oder Benzophenon.

Bei der wenigstens einen zweiten Komponente B handelt es sich vorzugsweise um eine Verbindung mit mindestens zwei funktionellen Gruppen, insbesondere um eine Verbindung mit mindestens zwei Gruppen, die sich z.B. in einer Michael-Addition an Doppelbindungen addieren können. Dies sind insbesondere Amingruppen, Thiolgruppen oder Phosphingruppen. Besonders bevorzugt werden Verbindungen mit mindestens zwei Amingruppen eingesetzt. Die wenigstens zweite Komponente B ist bevorzugt ausgewählt aus Verbindungen mit der nachfolgend abgebildeten allgemeinen Formel

R-(NH₂)n

wobei R ein Kohlenwasserstoff oder eine andere, Heteroatome enthaltende organische monomere, oligomere oder polymere Verbindung sein kann, und die eine lineare oder verzweigte Kette oder eine aus einem oder mehreren substituierten oder unsubstituierten aliphatischen oder aromatischen cyclischen Strukturen bestehende Gruppe sein kann, bei der an mindestens zwei Stellen Wasserstoffatome durch Amingruppen substituiert sind. Beispiele hierfür sind Ethylendiamin, Diethylentriamin, Triethylentetramin, Isophorondiamin, 1,6-Hexandiamin, Toluoldiamin, 4,4'-Diphenylmethandiamin, 2,4'-Diphenylmethandiamin, 1,3-Diaminopentane, 2,2,4-Trimethylhexan-1,6-diamin, 1,4-Diaminobutan, Polyethylenglycoldiamin, Polypropylenglycoldiamin, oder die Handelsprodukte Jeffamine D-400 oder Jeffamine D-2000 der Firma Huntsman oder die Härter Priamine 1071, Priamine 1073, Priamine 1074 oder Priamine 1075 der Firma Croda.

Vorzugsweise enthält die aushärtbare Masse auch mindestens eine weitere Komponente E, die die Reaktion zwischen der mindestens einen vernetzenden Komponente A und der mindestens einen zweiten Komponente B katalysiert. Bevorzugt werden hierfür nicht nucleophile Basen wie z.B. tertiäre Amine eingesetzt. Beispiele für diese weitere Komponente E sind 1,8-Diazabicyclo[5.4.0]undec-7-en (DBU), 1,5-Diazabicyclo[4.3.0]non-5-en (DBN), Triethylendiamin (DABCO), 4-(Dimethylamino)pyridin (DMAP), N,N-Diisopropylethylamin (DIPEA) oder 2,6-Ditert-butylpyridin.

Vorzugsweise handelt es sich bei der wenigstens einen dritten Komponente C um eine Verbindung mit mindestens zwei funktionellen Gruppen, insbesondere Epoxidfunktionen. Beispiele für die Komponente C sind Bisphenol-A-diglycidylether (DGEBA) sowie Oligomere daraus, die z.B. unter den Handelsnamen Epilox A in verschiedenen Varianten von der Firma Leuna-Harze vertrieben werden, Bisphenol-F-diglycidylether sowie Oligomere daraus, die z.B. unter den Handelsnamen Epilox F von der Firma Leuna-Harze vertrieben werden, 1,4-Butandioldiglycidylether, 1,6-Hexandioldiglycidylether, Trimethylolpropantriglycidylether, 1,3-Bis(2,3-epoxypropoxy)-2,2-dimethylpropan, 1,2-Epoxy-3-(2-methylphenoxy)propan, 1,4-Bis(2,3-epoxypropyloxy)butan, Cyclohexandimethanoldiglycidylether, Glycerintriclycitylether, Neopentylglycoldiglycidylether, Penthaerythritolpolyglycidylether, Polyethyleneglycoldiglycidylether Polypropyleneglycoldiglycidylether oder epoxydierte Pflanzenfette.

Das Mischungsverhältnis zwischen den Komponenten A, B und C ist in einer vorteilhaften Ausgestaltung so gewählt, dass nach Eintritt des ersten und des zweiten Ereignisses in dem mindestens einen ersten Bereich (i) mindestens 99% der Komponenten A, B und C in mindestens eines der sich bildenden Netzwerke eingebaut sind und höchstens 1% funktioneller Gruppen der Komponenten A, B und C verbleiben und dass nach alleinigem Eintritt des zweiten Ereignisses in dem mindestens einen zweiten Bereich (ii) mindestens 99% der Komponenten A, B und C in das zweite Netzwerk eingebaut sind und höchstens 1% funktioneller Gruppen der Komponenten A, B und C verbleiben.

Die aushärtbare Masse kann auch mindestens einen Füll- oder Verstärkungsstoff mit einem Anteil zwischen 1 und 99 Gew.-%, vorzugsweise zwischen 20 und 80 Gew.% und besonders bevorzugt zwischen 40 und 70 Gew.-% enthalten.

Das Aushärten der vorgeschlagenen aushärtbaren Masse erfolgt vorzugsweise derart, dass in mindestens einem Bereich der Masse, der eine höhere Netzwerkdichte erhalten soll als mindestens ein anderer Bereich, das erste Ereignis ausgelöst wird, das das erste Netzwerk ausbildet, und über das gesamte Volumen der Masse das zweite Ereignis ausgelöst wird, das das zweite Netzwerk ausbildet.

Im Folgenden werden Beispiele für aushärtbare Massen angeführt, die sich für den Einsatz beim vorgeschlagenen Verfahren eignen.

Mit dem vorgeschlagenen Verfahren und der vorgeschlagenen aushärtbaren Masse kann im Bereich der Elektronik das Dilemma der Wahl zwischen einer harten und einer weichen Vergussmasse vermieden werden, indem die Vorteile beider Varianten vereint werden. Mit dem Verfahren ist es darüber hinaus auch möglich, mit der variabel aushärtenden Vergussmasse einen gehäuselosen Verguss elektronischer Systeme, beispielsweise von Halbleiterbauelementen, Sensoren, Steuerungselektronik, Leistungselektronik u.a., zu realisieren, indem die harte Außenschicht die Funktion eines Gehäuses übernimmt. Dies kann in additiven Fertigungsverfahren wie zum Beispiel der Stereolithographie auch völlig werkzeuglos erfolgen. Die elektronischen Bauteile können dabei in vielen Bereichen wie beispielsweise in der Automobilbranche, in weißer Ware oder aber auch in der Unterhaltungselektronik gleichermaßen Einsatz finden.

### Kurze Beschreibung der Zeichnungen

Das vorgeschlagene Verfahren und die vorgeschlagene aushärtbare Masse werden nachfolgend anhand von Ausführungsbeispielen in Verbindung mit den Zeichnungen nochmals näher erläutert. Hierbei zeigen:
- Fig. 1: ein Beispiel für vergossene Bauteile gemäß dem Stand der Technik;
- Fig. 2: ein Beispiel für gemäß dem vorgeschlagenen Verfahren vergossene Bauteile;
- Fig. 3: ein weiteres Beispiel für gemäß dem vorliegenden Verfahren vergossene Bauteile;
- Fig. 4: ein weiteres Beispiel für gemäß dem vorliegenden Verfahren vergossene Bauteile;
- Fig. 5: eine schematische Darstellung der bei dem vorgeschlagenen Verfahren genutzten unterschiedlich dichten Netzwerke;
- Fig. 6: eine schematische Darstellung der basenkatalysierten Aza-Michael-Addition von Aminen an Acrylaten;
- Fig. 7: ein Zug-Dehnungs-Diagramm der Prüfkörper aus dem ersten Beispiel;
- Fig. 8: ein Diagramm, das den Verlauf der Shore-Härte A in Abhängigkeit von der Probentiefe zeigt;
- Fig. 9: ein Zug-Dehnungs-Diagramm der Prüfkörper aus dem zweiten Beispiel; und
- Fig. 10: ein Zug-Dehnungs-Diagramm der Prüfkörper aus dem dritten Beispiel.

### Wege zur Ausführung der Erfindung

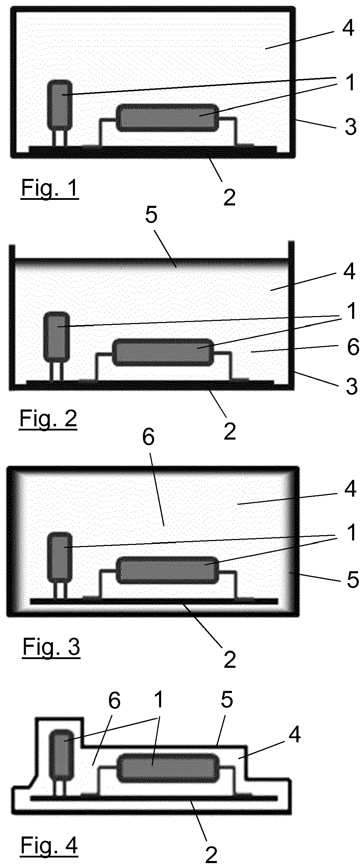

Die folgenden Figuren zeigen unterschiedliche Möglichkeiten zum Vergießen elektronischer Bauteile mit einer Vergussmasse. In Figur 1 ist hierbei das herkömmliche Verfahren gemäß dem Stand der Technik dargestellt, bei dem die elektronischen Bauteile 1 auf einer Platine 2 in ein Gehäuse 3 eingesetzt werden und anschließend mit einer relativ weich aushärtenden Vergussmasse 4 in dem Gehäuse 3 vergossen werden. Das Gehäuse 3 wird anschließend mit einem Gehäusedeckel vollständig verschlossen.

Bei dem erfindungsgemäßen Verfahren wird eine Vergussmasse eingesetzt, die abhängig von dem zur Aushärtung genutzten Aushärtemechanismus, beispielsweise Strahlungshärtung oder thermische Härtung, zu unterschiedlich steifen bzw. dichten Netzwerken aushärten kann. Dies ermöglicht über die Wahl und lokale Anwendung des jeweiligen Aushärtemechanismus die Einstellung lokal unterschiedlicher Steifigkeiten der Vergussmasse. Mit dem vorgeschlagenen Verfahren können dann die elektronischen Bauteile von einem weichen Kernmaterial der Vergussmasse umschlossen werden, das gleichzeitig eine steife Außenschicht bildet. Auf diese Weise lassen sich die Spannungen im Kernbereich abmildern und damit Beschädigungen der Elektronik vermeiden. Gleichzeitig kann durch die steife Außenschicht der ausgehärteten Vergussmasse die Gehäusefunktion oder zumindest ein Teil der Gehäusefunktion realisiert werden.

So zeigt beispielsweise Figur 2 ein erfindungsgemäßes Beispiel, bei dem die elektronischen Bauteile 1 auf einer Platine 2 zunächst in ein nach oben offenes Gehäuse 3 eingesetzt werden. Die Vergussmasse 4 wird anschließend in das Gehäuse eingefüllt und im oberen ersten Bereich 5 mit einem ersten Härtungsmechanismus zu einem ersten, dichteren Netzwerk ausgehärtet. Im zweiten Bereich 6, der die elektrischen Bauteile 1 direkt umschließt, wird die Vergussmasse 4 mit einem zweiten Härtungsmechanismus zu einem zweiten Netzwerk mit geringerer Netzwerkdichte ausgehärtet. Durch die höhere Netzwerkdichte im oberen Bereich 5 ist die ausgehärtete Vergussmasse in diesem Bereich deutlich steifer als im inneren Kernbereich, d.h. dem zweiten Bereich 6 mit dem zweiten Netzwerk, so dass durch diesen ersten Bereich 5 die Funktion des Gehäusedeckels übernommen werden kann. Eine zusätzliche Komponente zum Verschluss des Gehäuses wie bei der Ausgestaltung der Figur 1 ist hierfür nicht erforderlich.

Bei dem vorgeschlagenen Verfahren kann auch vollständig auf ein separates Gehäuse verzichtet werden, wie dies in dem Beispiel der Figur 3 schematisch angedeutet ist. Hier werden die elektronischen Bauteile 1 auf der Platine 2 von dem zweiten (weicheren) Bereich 6 der Vergussmasse 4 vollständig umschlossen. Dieser zweite Bereich 6 wird wiederum vom ersten (steiferen) Bereich 5 der Vergussmasse 4 vollständig ummantelt. Dieser erste Bereich 5 übernimmt hier die Funktion eines Gehäuses, das die elektronischen Bauteile 1 gegen Eindringen von Feuchtigkeit, Staub, Fremdkörpern, Wasser, Chemikalien usw. schützt. Eine derartige Ausgestaltung kann durch Vergießen in eine geeignete Vergussform erfolgen, die anschließend entfernt wird. Eine weitere Möglichkeit besteht in der Nutzung eines additiven Fertigungsverfahrens, bei dem die Vergussmasse 4 Schicht für Schicht aufgebracht und ausgehärtet wird, um die elektronischen Bauteile 1 auf der Platine 2 entsprechend vollständig zu ummanteln. Dadurch ist ein werkzeugloser und auch gehäuseloser Verguss der elektronischen Bauteile möglich. Bei diesem additiven Fertigungsverfahren erfolgt auch die Aushärtung schichtweise, d.h. jeweils nach dem Aufbringen der jeweiligen Schicht.

Mit einer derartigen additiven Fertigungstechnik besteht auch die Möglichkeit eines konturnahen Vergusses der elektronischen Bauteile 1 auf der Platine 2, wie dies in der Figur 4 schematisch angedeutet ist. Mit dem vorgeschlagenen Verfahren und der darin eingesetzten Gradientenvergussmasse ist somit ein werkzeugloser, gehäuseloser und auch konturnaher Verguss elektronischer Bauteile oder Bauteilgruppen möglich.

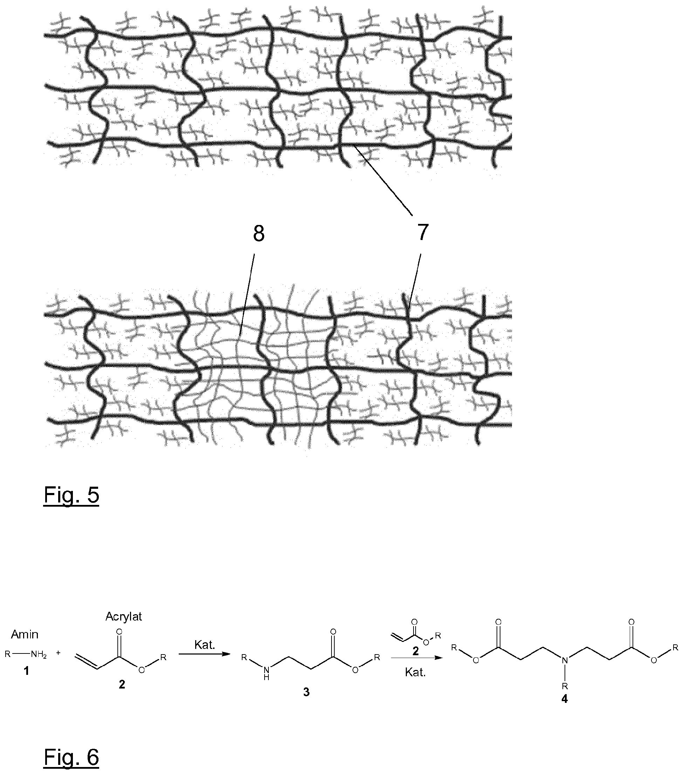

Bei dem vorgeschlagenen Verfahren wird eine aushärtbare Masse als Vergussmasse eingesetzt, die mittels unterschiedlicher Aushärtemechanismen zu unterschiedlich steifen Netzwerken ausgehärtet werden kann. Für die Entwicklung oder Bereitstellung einer derartigen Masse stehen dem Fachmann unterschiedliche Möglichkeiten und Materialkombinationen zur Verfügung. Im Folgenden Beispiel wird eine aushärtbare Masse hergestellt, bei der ein Härtungsmechanismus (zweiter Härungsmechanismus) über das gesamte Volumen der Masse wirkt und ein weitmaschiges Netzwerk mit geringer Netzwerkdichte generiert. Das daraus resultierende Material ist dann weich bis gummi-elastisch. Der weitere Härtungs- bzw. Vernetzungsmechanismus (erster Härtungsmechanismus) wirkt lokal, beispielsweise nur an der Oberfläche, und generiert eine hohe Netzwerkdichte, durch die ein steiferes Material erhalten wird. Dies ist in Figur 5 schematisch dargestellt. In der oberen Teilabbildung ist ein Netzwerk 7 mit geringer Netzwerkdichte dargestellt, das durch den zweiten Härtungsmechanismus erzeugbar ist, das gesamte Volumen erfasst und zu einem elastomeren Material führt. In der unteren Teilabbildung ist innerhalb des Netzwerkes 7 der oberen Teilabbildung lokal ein Bereich mit höherer Netzwerkdichte 8 zu erkennen, die durch einen lokal wirkenden ersten Härtungsmechanismus erreicht wird und zu einem steifen Material führt. Die vernetzende Komponente A der aushärtbaren Masse und die beiden Härtungsmechanismen sind dabei so gewählt, dass der zweite Härtungsmechanismus das gesamte Volumen der aushärtbaren Masse erfasst, während der erste Härtungsmechanismus nur lokal wirkt. Durch die Kombination dieser beiden Härtungsmechanismen kann damit die Netzwerkdichte der aushärtbaren Masse und damit deren Steifigkeit gezielt gesteuert werden.

Bei der Herstellung einer derartigen Masse ist darauf zu achten, dass beide Mechanismen zu einem stabilen Endzustand führen. Nach der Aushärtung dürfen sowohl im weichen als auch im steifen Bereich keine signifikanten Anteile von reaktiven Gruppen verbleiben, die eine Nachvernetzung der Masse verursachen können. Eine vollständige Härtung aller Komponenten ist die Voraussetzung für eine Langzeitstabilität bei wechselnden Temperaturen. Die zur Erhöhung der Netzwerkdichte nötigen funktionellen Gruppen sollten beispielsweise im ersten Härtungsschritt lokal abreagieren und im zweiten Härtungsschritt in das weitmaschige Netzwerk eingebaut werden. Dabei darf jedoch keine Erhöhung der Netzwerkdichte bzw. Steifigkeit erfolgen. Daher muss die wenigstens eine als vernetzende Komponente A verwendete Substanz auf zwei unterschiedlichen Wegen Netzwerke ausbilden können.

Ein Beispiel für geeignete Basismaterialien einer derartigen aushärtbaren Masse ist die Klasse der Acrylate als vernetzende Komponente A, die vielfältige Möglichkeiten der Netzwerkbildung aufweisen. Der einfachste Weg ist die radikalische Polymerisation, die in Anwesenheit eines Radikalbildners thermisch oder durch UV-Strahlung initiiert werden kann. Acrylate können außerdem anionisch oder kationisch polymerisiert werden. Ein weiterer Mechanismus zur Härtung von Acrylaten ist die Michael-Addition. Diese ermöglicht die basenkatalysierte Addition von Aminen an die C-C-Doppelbindung des Acrylats, wie dies beispielhaft in Figur 6 dargestellt ist. Diese Variante hat für das vorgeschlagene Verfahren Vorteile, da das Acrylat anders als bei der radikalischen Polymerisation nicht direkt sondern über aminische Härter als zweite Komponente B mit anderen Acrylatgruppen verknüpft wird. Das bedeutet, dass die Netzwerkdichte bei dieser Art der Polymerisation über die Art des aminischen Härters gesteuert werden kann und sich somit deutlich von der Netzwerkdichte der radikalischen Polymerisation unterscheidet. Bei Verwendung langkettiger, flexibilisierender aminischer Härter in Kombination mit Acrylaten, die als Homopolymer hochsteife Materialien mit hoher T_{g} (T_{g}: Glasübergangstempertur) bilden, lassen sich weiche Materialien mit elastomerem Charakter erzeugen. Die Michael-Addition von Aminen an Acrylate stellt somit einen bevorzugten Mechanismus dar, welcher die zuvor beschriebenen Bedingungen erfüllt. Das vorgeschlagene Verfahren ist jedoch weder auf Acrylate noch auf die obigen Mechanismen beschränkt, da der Fachmann jederzeit auch andere Basismaterialien und Mechanismen findet, die die Bedingungen für das vorgeschlagene Verfahren erfüllen.

Im vorliegenden Beispiel wird die radikalische Polymerisation der Acrylate als Mechanismus gewählt, mit dem die Erzeugung des steifen Materials lokal ausgelöst werden kann. Diese wird nicht thermisch, sondern durch UV-Behandlung mit einem geeigneten Photoinitiator aktiviert. Insbesondere in der hier vorgesehenen Anwendung einer Vergussmasse zum gehäuselosen Vergießen elektronischer Bauteile bietet diese Variante deutliche Vorteile. Die Strahlungshärtung erlaubt das gezielte Auslösen der radikalischen Acrylat-Polymerisation in den äußeren Bereichen der aushärtbaren Masse und somit die Erzeugung einer festen Außenhaut, die später die Gehäusefunktion übernehmen kann. Zugleich kann sowohl über die Strahlungsintensität bzw. -dauer als auch über die Art des Photoinitiators oder etwaige Füllstoffe die Eindringtiefe der UV-Strahlung und somit die Dicke der festen Außenschicht gesteuert werden.

Um die radikalische Polymerisation von Acrylaten und die Michael-Addition von Aminen an Acrylate in einer Formulierung einer aushärtbaren Masse mit einstellbaren mechanischen Eigenschaften zu kombinieren, wird folglich ein Acrylat-Harz (Komponente A), welches als Homopolymer eine sehr hohe Steifigkeit und Festigkeit aufweist, und ein geeigneter Photoinitiator (Komponente D) benötigt. Für die Michael-Addition hingegen benötigt man flexibilisierende aminische Härter (Komponente B), um auf diese Weise ein Material mit elastomerem Charakter zu erzeugen, und eine nicht-nukleophile, starke Base als Katalysator (Komponente E). In den bestrahlten Bereichen reagiert das Acrylat mit sich selbst und in den unbestrahlten Bereichen mit den aminischen Härtern. Das Acrylat ist somit sowohl im weichen als auch im steifen Bereich vollständig aufgebraucht und kann nicht mehr nachvernetzen. Nach der Ausbildung eines steifen Materials durch UV-Behandlung verbleiben die nicht umgesetzten aminischen Härter im Netzwerk. Diese stellen im Hinblick auf eine mögliche Nachvernetzung keine Gefahr dar. Sie können jedoch in einer bevorzugten Ausgestaltung auch im Netzwerk gebunden werden, um ein Auswaschen dieser Bestandteile und damit einhergehend eine Veränderung der Materialeigenschaften über die Zeit zu vermeiden. Dies kann beispielsweise über ein Epoxidharz als weitere Komponente C erfolgen.

Die Anzahl an kommerziell erhältlichen mehrfunktionellen Acrylaten ist groß und umfasst z.B. die Produkte SR834, SR833S und SR368 der Firma Sartomer/ Arkema sowie einige Typen aus der Serie VISIOMER der Firma Evonik. Die Auswahl an aminischen Härtern ist ebnfalls sehr groß und umfasst daher eine Vielzahl von Verbindungen. Beispiele sind die Härter DETA, TETA, 2,2,4-Trimethylhexan-1,6-diamin, IPDA oder 1,4-Diaminobutan der Firma Sigma-Aldrich, die Härter Jeffamine D-400 oder Jeffamine D-2000 der Firma Huntsman oder die Härter Priamine 1071, Priamine 1073, Priamine 1074 oder Priamine 1075 der Firma Croda.

Soll eine zweite Harzkomponente eingesetzt werden, um die nicht umgesetzten aminischen Härter im Netzwerk zu binden wie weiter oben beschrieben, so bieten sich beispielsweise verschiedene Epoxide der Firma Leuna-Harze und Ipox-Chemicals an, welche nach der Bestrahlung mit den zurückbleibenden Aminen reagieren können. So können hierfür beispielsweise die Produkte Epilox P 13-20, Epilox P 13-26, Epilox P 13-42, Epilox P 13-30 oder DGEBA der Firma Leuna-Harze sowie das Produkt IPOX ER 15 der Firma Ipox-Chemicals eingesetzt werden. Als Photoinitiatoren, Beschleuniger und Katalysatoren können beispielsweise Irgacure 184 oder Irgacure 819 der Firma BASF als Photoinitiatoren für radikale Polymerisation der Acrylate, Accelerator 960-1 der Firma Huntsman als Beschleuniger für aminische Epoxidhärtung und Diazabicyclononen (DBN), Diazabicycloundecen (DBU), Triazabicyclodecen (TBD), Triethylendiamin (DABCO) der Firma Sigma-Aldrich als nicht-nukleophile Basen als Katalysator für die Michael-Addition eingesetzt werden.

Die Hauptkomponente der im vorliegenden Beispiel gewählten Formulierung der Vergussmasse bzw. aushärtbaren Masse ist das Acrylat, bevorzugt SR833S, SR368 sowie Mischungen der beiden. Mit steigendem Anteil an Fremdkomponenten bzw. Zusatzstoffen (Amine, Epoxid, Initiator, Basenkatalysator) wird die UV-Härtung zunehmend behindert, was zu einer Abnahme der Steifig- oder Festigkeit im belichteten Bereich führen kann. Ein Verhältnis von 0,5 bis 0,65 g Fremdkomponenten je 1 g Acrylat bietet sich dabei als besonders vorteilhaft an. Die Fremdkomponenten setzen sich zusammen aus einem großen Anteil verschiedener Amine, einem kleinen Anteil an Epoxid und einem sehr kleinen Anteil an Initiator/Katalysator/ Beschleuniger. Die Komponenten wurden vereint und anschließend mit einem Speedmixer™ DAC400.1 VAC-P der Firma Hauschild (1:30 min, 2500 rpm, 20 mbar) gemischt, um die gewünschte aushärtbare Masse zu erhalten.

Für Tests wurden Prüfkörper für Zugversuche aus der aushärtbaren Masse hergestellt. Hierzu wurde die aushärtbare Masse in Silikonformen in Zugstabform gefüllt. Um ein weiches Material zu erhalten, wurden die unbelichteten Proben bei verschiedenen Härtungstemperaturen ausgelagert. Um ein steifes Material zu erhalten, wurden die Proben zunächst in der UV-Bestrahlungskammer (UVA-CUBE 2000, Hoehnle, 2000 W, 15 cm Abstand zur Röhre) bestrahlt und danach erst im Ofen ausgelagert. Die Härtungstemperaturen und -dauern sind den nachfolgenden Beispielen zu entnehmen. Die auf diese Weise hergestellten Proben wurden anschließend einer Zugprobe unterzogen, auf Shore-Härte A geprüft und anhand DSC (dynamische Differenzkalorimetrie) und DMA (dynamisch-mechanische Analyse) auf Glastemperaturen untersucht, um die Unterschiede der mechanischen und thermischen Eigenschaften zu verdeutlichen. Hierzu werden nachfolgend drei Beispiele aus einer Vielzahl von durchgeführten Versuchsreihen gezeigt.

### Beispiel 1:

Im ersten Beispiel dient SR368 als Acrylat-Komponente. Aminoterminierte Polyether unterschiedlicher Kettenlänge (Jeffamine D-400 und D-2000) sowie IPDA dienen als aminische Komponenten. Als Epoxidharz wird der Formulierung das cycloaliphatische IPOX ER 15 zum Binden der Aminhärter beigemischt. DBU wurde zur Katalyse der Michael-Addition eingesetzt. Als Photoinitiatoren dienen Irgacure 819 für die Herstellung von Zugproben mit 2 mm Dicke und Irgacure 184 für Versuche zur Eindringtiefe der Strahlung. Die damit hergestellte Formulierung einer aushärtbaren Masse weist die in der nachfolgenden Tabelle angegebene Zusammensetzung auf.

| **Komponente** | **Menge** |
|---|---|
| SR368 | 5 g |
| IPOX ER 15 | 0.5 g |
| Jeffamine D-2000 | 1 g |
| Jeffamine D-400 | 0.7 g |
| IPDA | 0.85 g |
| Irgacure 184 oder 819 | 10 mg |
| DBU | 50 mg |

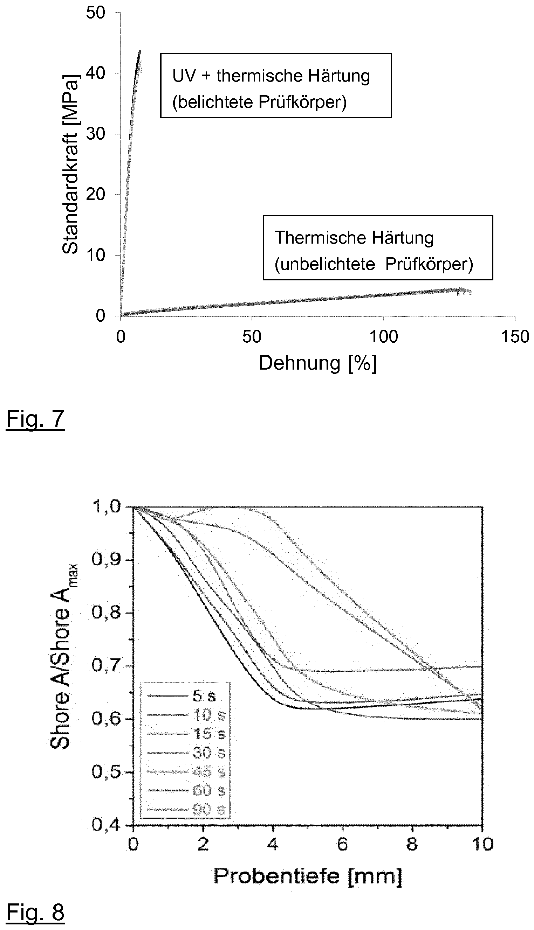

Nach dem Füllen der Prüfkörperformen wurde die Hälfte der Proben zwei Minuten im UVA-CUBE 2000 bestrahlt, während die andere Hälfte vor Lichteinstrahlung geschützt wurde. Anschließend wurden alle Proben gemeinsam für zwei Stunden bei 110°C und eine Stunde bei 180°C im Ofen gehärtet. Bereits nach dem Bestrahlen sind die zuvor transparenten Probekörper opak, was auf eine Phasenseparation zwischen dem polymerisierten Acrylat und dem Epoxid bzw. den aminischen Härtern hindeutet. Dies ist von Vorteil, da die so auspolymerisierte Acrylatphase die physikalischen und mechanischen Eigenschaften des Homopolymers behalten sollte, also eine hohe Glasübergangstemperatur T_{g} und eine hohe Steifigkeit. Die ausschließlich thermisch ausgehärteten Proben behalten ihre Transparenz. Es bildet sich also ein homogenes Netzwerk. Im belichteten Bereich entstand ein steifes, hartes Material und im unbelichteten Bereich ein weiches, gummi-elastisches Material. Die Messergebnisse der Zugprobe sind im Zug-Dehnungs-Diagramm der Figur 7 sowie der nachfolgenden Tabelle dargestellt.

| Prüfkörper | Zugversuche | | | Shore-Härte A | DSC | DMA |
|---|---|---|---|---|---|---|
| | E-Modul [MPa] | σ_{B} [MPa] | ε_{B} [%] | | T_{g} [°C] | T_{g} [°C] |
| Steif | 850.1 | 41.7 | 7.6 | 46 | - | 132.1 |
| Weich | 21.3 | 3.6 | 130.7 | 76 | 10.7 | - |

Die Figur zeigt deutlich die hohe Steifigkeit der Prüfkörper durch UV- und thermische Härtung, während die Prüfkörper mit rein thermischer Härtung eine hohe Elastizität aufweisen. Die rein thermisch ausgehärtete Masse verhält sich ähnlich wie ein Elastomer, mit äußerst geringer Steifigkeit und hoher Dehnbarkeit. Wird die Masse jedoch zunächst bestrahlt, erhöht sich die Steifigkeit enorm auf Kosten der Dehnbarkeit. Auch die Bedingung bezüglich eines stabilen Gradienten wird durch diese beispielhafte Formulierung erfüllt. Hierzu wurden die Prüfkörper in der DSC auf Nachreaktionen untersucht. Weder in der weichen noch in der steifen Probe wurden im Temperaturbereich zwischen -75°C und 200°C Nachreaktionen festgestellt. Die reaktiven Gruppen in beiden Probenarten sind demnach vollständig verbraucht, so dass durch die Bestrahlung ein dauerhafter Steifigkeitsunterschied erzeugt werden kann.

Um zu überprüfen, ob sich diese Art der Formulierung zum gehäuselosen Vergießen elektronischer Bauteile eignet, wurde der Photoinitiator Irgacure 819 durch Irgacure 184 ersetzt. Irgacure 819 zerfällt bereits durch Bestrahlung mit Wellenlängen, die im sichtbaren Bereich des Spektrums liegen, und eignet sich daher zur Härtung dickerer Schichten. Irgacure 184 hingegen besitzt ein Absorptionsmaximum bei Wellenlängen um 250 nm, also genau innerhalb des Bereiches, in dem auch mit Absorptionen der verwendeten Harzsysteme zu rechnen ist. Dadurch soll gewährleistet werden, dass die Eindringtiefe der Strahlung im relevanten Wellenlängenbereich möglichst niedrig gehalten wird, um auf diese Weise eine dünne, steife Randschicht zu generieren, die später die Gehäusefunktion übernehmen kann. Um den Einfluss der Bestrahlungsdauer auf die Eindringtiefe der UV-Strahlung bei der Verwendung von Irgacure 184 zu untersuchen, wurden Polylstyrol-Küvetten mit schwarzem Isolierband umwickelt und mit jeweils 3 g der oben aufgeführten Formulierung befüllt. Anschließend wurden die Proben unterschiedlich lang UV-Strahlung ausgesetzt und danach gemäß dem obigen Heizprogramm thermisch ausgehärtet. Figur 8 zeigt den Verlauf der Oberflächenhärte in Abhängigkeit von der Probentiefe bei unterschiedlichen Bestrahlungsdauern.

Wie aus der Figur 8 erkennbar ist, nimmt die Eindringtiefe der UV-Strahlung mit zunehmender Bestrahlungsdauer zu. Ab einer Dauer von ca. 60 s ist ein Sättigungswert von ca. 4 mm Eindringtiefe erreicht. Die Oberflächenhärte der Probe sinkt am Übergang von steifem zu weichem Bereich ab. Schon nach wenigen Millimetern unter der steifen Schicht zeigte sich eine 30-40 % geringere Shore-Härte als im steifen Bereich. Dieser Versuch zeigt, dass die Schichtdicke der äußeren steifen Schicht, die später die Gehäusefunktion übernehmen soll, über die Art des Photoinitiators und die Bestrahlungsdauer gezielt eingestellt werden kann.

### Beispiel 2:

Im zweiten Beispiel dienen SR368 und SR833S als Acrylat-Komponenten. Polyether unterschiedlicher Kettenlänge (Jeffamine D-400 und D-2000) sowie IPDA dienen als aminische Komponenten. Als Epoxidharz wird der Formulierung DGEBA zum Binden der Aminhärter beigemischt. DBU wird zur Katalyse der Michael-Addition eingesetzt. Als Photoinitiator dient Irgacure 819. Aus diesen Bestandteilen wird folgende Formulierung der aushärtbaren Masse entwickelt:

| **Komponente** | **Menge** |
|---|---|
| SR368 | 1 g |
| SR833S | 4 g |
| DGEBA | 0.5 g |
| Jeffamine D-2000 | 1 g |
| Jeffamine D-400 | 0.7 g |
| IPDA | 0.85 g |
| Irgacure 819 | 10 mg |
| DBU | 50 mg |

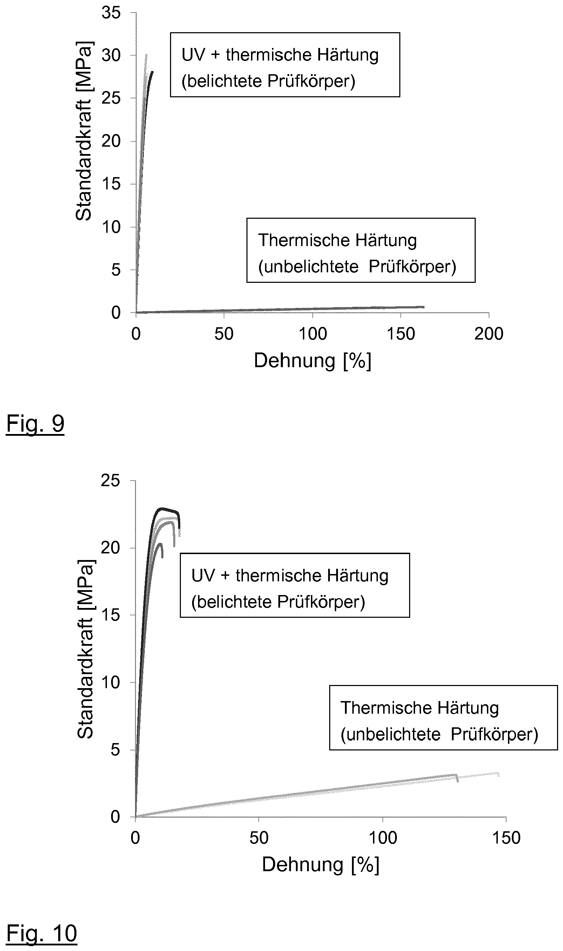

Nach dem Füllen der Prüfkörperformen wurde die Hälfte der Proben 5 Minuten im UVA-CUBE 2000 bestrahlt, während die andere Hälfte vor Lichteinstrahlung geschützt wurde. Anschließend wurden alle Proben gemeinsam für 2 Stunden bei 110 °C und 2 Stunden bei 180 °C im Ofen gehärtet. Hier wurden im belichteten Bereich steife, transparente Prüfkörper erhalten und folglich keine Phasentrennung erreicht. Das Acrylat SR833S führte zur besseren Mischung und Integration der nicht umgesetzten Komponenten nach der Bestrahlung. Die Transparenz ist hier kein Zeichen für eine geringere Steifigkeit, was durch die in Figur 9 und der nachfolgenden Tabelle dargestellten Messergebnisse belegt wird. Figur 9 zeigt hier wiederum die Messergebnisse der Zugprobe in einem Zug-Dehnungs-Diagramm.

| Prüfkörper | Zugversuche | | | Shore-Härte A | DSC | DMA |
|---|---|---|---|---|---|---|
| | E-Modul [MPa] | σ_{B} [MPa] | ε_{B} [%] | | T_{g} [°C] | T_{g} [°C] |
| Steif | 606.7 | 26.8 | 7.2 | 10 | - | 116.5 |
| Weich | 0.7 | 0.5 | 144.1 | 70 | -5.4 | - |

Diese Formulierung liefert im unbelichteten Bereich ein noch weicheres Material als in Beispiel 1, was an den niedrigeren Werten für Glastemperatur, Shore-Härte A und E-Modul zu erkennen ist. Die belichteten Prüfkörper weisen nach der Härtung ebenfalls geringere Steifig- bzw. Festigkeiten auf, was für eine Gehäusefunktion ausreichend ist. Der große Vorteil der Kombination von SR368 und SR833S ist die Verringerung der Viskosität mit steigendem Anteil an SR833S. Je nach Anteil an SR833S lässt sich die Viskosität der Gesamtmischung steuern, was für den Einsatz von Füllstoffen in Hinblick auf Schwindung und Wärmeleitfähigkeit von Vorteil sein kann. Der Einsatz des zweiten Photoinitiators Irgacure 184 zur Untersuchung der Eindringtiefe führt in dieser Formulierung zu einem sehr ähnlichen Ergebnis wie in Beispiel 1, wobei hier nicht mehr optisch zwischen steifem und weichem Bereich unterschieden werden konnte. Die Steifigkeit der belichteten Außenschicht lässt sich in dieser Formulierung auch über die Art des Initiators und die Belichtungsdauer einstellen. Es wurden keine Nachreaktionen im Bereich -75 °C und 200 °C beobachtet, d.h. die Härtung war vollständig und alle reaktiven Gruppen sind verbraucht.

### Beispiel 3:

Im dritten Beispiel dient SR833S als Acrylat-Komponente. Die Priamine (eine Mischung aus aminierten Monomeren, Dimeren und Trimeren der Ölsäure; aliphatisches Gerüst) und 2,2,4-Trimethylhexan-1,6-diamin dienen als aminische Komponenten. Als Epoxidharz wird der Formulierung DGEBA zum Binden der Aminhärter beigemischt. DBU wird zur Katalyse der Michael-Addition eingesetzt. Als Photoinitiator dient Irgacure 819. Aus diesen Bestandteilen wird folgende Formulierung der aushärtbaren Masse entwickelt:

| **Komponente** | **Menge** |
|---|---|
| SR833S | 5 g |
| DGEBA | 0.75 g |
| Priamine 1075 | 0.74 g |
| 2,2,4-Trimethylhexan-1,6-diamin | 1.26 g |
| Irgacure 819 | 10 mg |
| DBU | 50 mg |

Nach dem Füllen der Prüfkörperformen wurde die Hälfte der Proben 5 Minuten im UVA-CUBE 2000 bestrahlt, während die andere Hälfte vor Lichteinstrahlung geschützt werden musste. Anschließend wurden alle Proben gemeinsam für 2 Stunden bei 110 °C, 2,5 Stunden bei 150 °C und 1 Stunde bei 180 °C im Ofen gehärtet. Auch hier werden nur transparente Prüfkörper erhalten, d.h. die überschüssigen Amine/Epoxide sind mischbar mit dem Acrylatnetzwerk und es entsteht keine Phasentrennung. Die Messergebnisse der Zugproben sind in Figur 10 und der nachfolgenden Tabelle gezeigt.

| Prüfkörper | Zugversuche | | | Shore-Härte A | DSC | DMA |
|---|---|---|---|---|---|---|
| | E-Modul [MPa] | σ_{B} [MPa] | ε_{B} [%] | | T_{g} [°C] | T_{g} [°C] |
| Steif | 566 | 20.5 | 15.6 | 24 | 27.1 und 185.2 | - |
| Weich | 4.2 | 2.9 | 138.6 | 74 | 12.1 | - |

Auch hier wird ein deutlicher Steifigkeitsunterschied erreicht und damit der Einsatz als Vergussmasse bei dem vorgeschlagenen Verfahren ermöglicht. Der Nutzen der hier verwendeten Amine mit aliphatischem Grundgerüst (Priamine und 2,2,4-Trimethylhexan-1,6-diamin) ist eine höhere Temperaturstabilität der gehärteten Materialien. Weicher und steifer Teil der Vergussmasse behalten ihre Eigenschaften auch nach längerer Einlagerung bei erhöhten Temperaturen bei, was einen deutlichen Vorteil im Vergleich zu Beispiel 1 und 2 darstellt. Ein Einsatz oberhalb 100 °C könnte mit dieser Formulierung realisierbar sein. Hier wurde ebenfalls keine Nachvernetzung im Bereich -50 °C bis 250 °C beobachtet, was für einen vollständigen Umsatz aller Komponenten spricht. Die Schichtdicke der steifen Außenschicht kann auch hier über die Belichtungsdauer gesteuert werden.

Manche der bisher vorgeschlagenen Verbindungen sind zwar in den gezeigten Beispielen nicht aufgeführt, können aber in entsprechenden Formulierungen ebenfalls für das vorgeschlagene Verfahren und die vorgeschlagene aushärtbare Masse eingesetzt werden. Diese Verbindungen besitzen alle eine gewisse Wirkung auf die Härtung und können zur Modifikation eingesetzt werden. Zum Beispiel dienen das Acrylat SR834 sowie die Basen DBN bzw. DABCO der Verlangsamung der Härtungsreaktionen im Vergleich zu den oben aufgeführten Beispielen, wobei die anderen Verbindungen meist zur Beschleunigung der Reaktionen geeignet sind. Durch den Einsatz mancher Epoxide lässt sich die Steifig- bzw. Festigkeit beider Bereiche ändern, was ebenfalls eine wichtige Stellschraube darstellt. Alle Verbindungen haben ihren eigenen Nutzen in den entwickelten Formulierungen und lassen sich daher unabhängig von den hier gezeigten Beispielen ebenfalls erfindungsgemäß einsetzen.

Zusammenfassend lässt sich feststellen, dass derartige Formulierungen als Vergussmasse bzw. aushärtbare Masse mit variablen mechanischen Eigenschaften einsetzbar sind. Durch Bestrahlung mit UV- oder sichtbarem Licht kann die Steifigkeit der Masse gezielt gesteuert und insbesondere lokal erzeugt werden. Gleichzeitig konnte in Beispiel 1 gezeigt werden, dass über die Art des Photoinitiators und die Bestrahlungsintensität und -dauer die Eindringtiefe der relevanten Strahlung (Schichtdicke des steifen Bereichs) kontrolliert werden kann. Somit kann durch Bestrahlung eine Art Gehäusefunktion generiert werden, während das Innere der Masse weich bleibt und die Elektronik möglichst spannungsarm umhüllt wird. Bedingung für eine Anwendung ist eine vollständige Härtung aller Komponenten der aushärtbaren Masse, wobei die Grundkomponente vorzugsweise im zeitlich ersten Härtungsschritt (bspw. UV; erster Härtungsmechanismus) lokal vernetzen und im anschließend durchgeführten zweiten Härtungsschritt (bspw. thermisch; zweiter Härtungsmechanismus) ohne Steifigkeitserhöhung in das weitmaschige Netzwerk eingebaut werden sollte. Diese Bedingung kann beispielsweise mit einer Kombination aus lichtinduzierter Acrylatvernetzung und basenkatalysierter Michael-Addition erfüllt werden. Der Fachmann ist aber selbstverständlich ohne weiteres in der Lage, auch andere Mechanismen und/oder Komponenten bzw. Formulierungen von aushärtbaren Massen zu finden, die die obigen Bedingungen erfüllen.

Die entwickelten Formulierungen sollten vorzugsweise so gewählt werden, dass der bei Aushärtung erzeugte Schrumpf und die damit einhergehenden Spannungen minimal sind. Außerdem erzeugen elektronische Bauteile meist Wärme, die abgeführt werden muss. An dieser Stelle ist eventuell der Einsatz von Füllstoffen von Vorteil. Im Elektronikbereich sind meist nur elektrisch-isolierende, aber thermischleitfähige Füllstoffe sinnvoll. Dazu gehören z.B. Quarz, Aluminiumverbindungen (Oxid, Hydroxid, Böhmit, Nitrid), Bornitrid und Siliziumkarbid. Zahlreiche Versuche mit den genannten Füllstoffen zeigten eine deutliche Schwindungsreduktion und Steigerung der Wärmeleitfähigkeit bei Füllstoffgehalten oberhalb 60 Gew.-%. Die maximale Verarbeitungsviskosität von Vergussmassen liegt bei 1000-10000 mPa*s, was auch bei hohen praxisüblichen Füllgraden mit den hier vorgeschlagenen Formulierungen zu erreichen ist.

Bei dem vorgeschlagenen Verfahren werden aus ein und derselben Formulierung einer aushärtbaren Masse zwei hinsichtlich ihrer thermischen und mechanischen Eigenschaften komplett unterschiedliche Materialien erzeugt. Damit lassen sich Gehäusungen für elektronische Bauteile realisieren, in denen eine weiche Phase einen deutlichen Glasübergang bei niedrigen Temperaturen besitzt, wohingegen in der steifen Phase Glasübergangstemperaturen von beispielsweise über 110°C erreicht werden. In der Oberflächenhärte und in der Steifigkeit werden dadurch signifikant unterschiedliche Eigenschaften erzielt. Das Verfahren erlaubt damit das Vergießen elektronischer Bauteile oder Bauteilgruppen mit einer Gehäusefunktion aus der Vergussmasse heraus, während das Innere der Vergussmasse weich bleibt. Diese Gehäusefunktion kann in einer besonderen Ausgestaltung durch einen nur kurzen Bestrahlungsschritt im Sekundenbereich erzeugt werden.

### Bezugszeichenliste

- 1: Elektronisches Bauteil
- 2: Platine
- 3: Gehäuse
- 4: Vergussmasse
- 5: erster Bereich
- 6: zweiter Bereich
- 7: Netzwerk mit geringer Netzwerkdichte
- 8: Netzwerk mit hoher Netzwerkdichte

## Patentansprüche

1. Verfahren zum Vergießen elektronischer Bauteile oder Bauteilgruppen, bei dem
- das Bauteil (1) oder die Bauteilgruppe in eine Vergussmasse (4) eingebettet wird, die über wenigstens einen Vernetzungsprozess ausgehärtet wird,
wobei
- eine Vergussmasse (4) eingesetzt wird, die wenigstens eine vernetzende Komponente A enthält, die homogen in der Vergussmasse (4) verteilt ist und zu wenigstens zwei unterschiedlichen Netzwerken vernetzen kann, von denen ein erstes Netzwerk (8) durch die mindestens eine vernetzende Komponente A alleine gebildet wird, wobei eine zumindest partielle Vernetzung zum ersten Netzwerk (8) in mindestens einem ersten Bereich (5) der Vergussmasse (4) über ein erstes Ereignis auslösbar ist,
- wenigstens eine zweite Komponente B enthält, die homogen in der Vergussmasse (4) verteilt ist und mit der die wenigstens eine vernetzende Komponente A ein zweites (7) der wenigstens zwei unterschiedlichen Netzwerke ausbilden kann, das eine geringere Netzwerkdichte aufweist als das erste Netzwerk (8), wobei die Vernetzung zu dem zweiten Netzwerk (7) über ein zweites Ereignis in mindestens einem zweiten Bereich (6) der Vergussmasse (4) auslösbar ist, in dem das erste Netzwerk (8) nicht oder nur partiell ausgebildet wurde, und
- wenigstens eine dritte Komponente C enthält, die homogen in der Vergussmasse (4) verteilt ist und nach der zumindest partiellen Vernetzung zum ersten Netzwerk (8) mit noch nicht vernetzten Anteilen der wenigstens einen zweiten Komponente B im ersten (5) und zweiten Bereich (6) zu einem weiteren Netzwerk reagiert, wobei die Reaktion der dritten Komponente C mit der zweiten Komponente B durch das zweite Ereignis ausgelöst wird, und
- die wenigstens eine vernetzende Komponente A der Vergussmasse (4) in wenigstens einem vom elektronischen Bauteil (1) oder der elektronischen Bauteilgruppe beabstandeten Bereich als erstem Bereich (5) zumindest partiell zu dem ersten Netzwerk (8) ausgehärtet und wenigstens in einem das elektronische Bauteil (1) oder die elektronische Bauteilgruppe einschließenden und unmittelbar umgebenden Bereich als zweitem Bereich (6) zu dem zweiten Netzwerk (7) ausgehärtet wird.

2. Verfahren nach Anspruch 1,
**dadurch gekennzeichnet,**
**dass** die wenigstens eine vernetzende Komponente A und die wenigstens eine zweite Komponente B so gewählt werden, dass sich die zwei unterschiedlichen Netzwerke im Elastizitätsmodul um wenigstens einen Faktor 2 unterscheiden.

3. Verfahren nach Anspruch 1 oder 2,
**dadurch gekennzeichnet,**
**dass** das zu vergießende elektronische Bauteil (1) oder die elektronische Bauteilgruppe in ein nach oben offenes Gehäuse (3) eingebracht und die Vergussmasse (4) anschließend in das Gehäuse (3) eingefüllt wird, um das elektronische Bauteil (1) oder die elektronische Bauteilgruppe mit der Vergussmasse (4) zu vergießen, wobei die wenigstens eine vernetzende Komponente A der Vergussmasse (4) in einem eine obere Begrenzungsfläche der Vergussmasse (4) beinhaltenden Bereich als erstem Bereich (5) zumindest partiell zu dem ersten Netzwerk (8) und wenigstens im verbleibenden Bereich als zweitem Bereich (6) zu dem zweiten Netzwerk (7) ausgehärtet wird.

4. Verfahren nach Anspruch 1 oder 2,
**dadurch gekennzeichnet,**
**dass** die vernetzende Komponente A in einer Schicht der Vergussmasse (4) als erstem Bereich (5) zu dem ersten Netzwerk (8) ausgehärtet wird, die eine äußere Begrenzungsfläche der Vergussmasse (4) bildet und den zweiten Bereich (6) mit dem elektronischen Bauteil (1) oder der elektronischen Bauteilgruppe vollkommen umschließt.

5. Verfahren nach Anspruch 4,
**dadurch gekennzeichnet,**
**dass** die Vergussmasse (4) beim Vergießen des elektronischen Bauteils (1) oder der elektronischen Bauteilgruppe so geformt und ausgehärtet wird, dass eine äußere Form der ausgehärteten Vergussmasse (4) einer Kontur des elektronischen Bauteils (1) oder der elektronischen Bauteilgruppe angenähert ist.

6. Verfahren nach einem der Ansprüche 1, 2, 4 oder 5,
**dadurch gekennzeichnet,**
**dass** die Vergussmasse (4) beim Vergießen des elektronischen Bauteils (1) oder der elektronischen Bauteilgruppe mit einem additiven Fertigungsverfahren schichtweise aufgetragen und ausgehärtet wird.

7. Aushärtbare Masse, die für das Verfahren nach einem der vorangehenden Patentansprüche als Vergussmasse (4) einsetzbar ist und die
- wenigstens eine vernetzende Komponente A enthält, die homogen in der aushärtbaren Masse verteilt ist und zu wenigstens zwei unterschiedlichen Netzwerken vernetzen kann, von denen ein erstes Netzwerk (8) durch die mindestens eine vernetzende Komponente A alleine gebildet wird, wobei eine zumindest partielle Vernetzung zum ersten Netzwerk (8) in mindestens einem ersten Bereich (i) der aushärtbaren Masse über ein erstes Ereignis auslösbar ist,
- wenigstens eine zweite Komponente B enthält, die homogen in der aushärtbaren Masse verteilt ist und mit der die wenigstens eine vernetzende Komponente A ein zweites (7) der wenigstens zwei unterschiedlichen Netzwerke ausbilden kann, das eine geringere Netzwerkdichte aufweist als das erste Netzwerk (8), wobei die Vernetzung zu dem zweiten Netzwerk (7) über ein zweites Ereignis in mindestens einem zweiten Bereich (ii) der aushärtbaren Masse auslösbar ist, in dem das erste Netzwerk (8) nicht oder nur partiell ausgebildet wurde, und
- wenigstens eine dritte Komponente C enthält, die homogen in der aushärtbaren Masse verteilt ist und nach der zumindest partiellen Vernetzung zum ersten Netzwerk (8) mit noch nicht vernetzten Anteilen der wenigstens einen zweiten Komponente B im ersten (i) und zweiten Bereich (ii) zu einem weiteren Netzwerk reagiert, wobei die Reaktion der dritten Komponente C mit der zweiten Komponente B durch das zweite Ereignis ausgelöst wird.

8. Aushärtbare Masse nach Anspruch 7,
**dadurch gekennzeichnet,**
**dass** die vernetzende Komponente A, die zweite Komponente B und die dritte Komponente C so gewählt sind, dass sich der erste (i) und zweite Bereich (ii) im Elastizitätsmodul um mindestens einen Faktor 2 unterscheiden.

9. Aushärtbare Masse nach Anspruch 7 oder 8,
**dadurch gekennzeichnet,**
**dass** es sich bei dem ersten Ereignis um eine Behandlung mit sichtbarem oder UV-Licht handelt.

10. Aushärtbare Masse nach einem der Ansprüche 7 bis 9,
**dadurch gekennzeichnet,**
**dass** es sich bei dem zweiten Ereignis um eine Wärmebehandlung handelt.

11. Aushärtbare Masse nach einem der Ansprüche 7 bis 10,
**dadurch gekennzeichnet,**
**dass** es sich bei der wenigstens einen vernetzenden Komponente A um eine Verbindung mit mindestens zwei funktionellen Gruppen, insbesondere Doppelbindungen, handelt.

12. Aushärtbare Masse nach einem der Ansprüche 7 bis 11,
**dadurch gekennzeichnet,**
**dass** sie mindestens eine weitere Komponente D enthält, welche durch Bestrahlung mit sichtbarem oder UV-Licht Radikale erzeugt, die in der Lage sind, die wenigstens eine vernetzende Komponente A durch radikalische Kettenreaktion zu vernetzen.

13. Aushärtbare Masse nach Anspruch 12,
**dadurch gekennzeichnet,**
**dass** es sich bei der mindestens einen durch Bestrahlung Radikale bildenden Komponente D um Bis(2,4,6-trimethylbenzoyl)-phenylphosphinoxid, 1-Hydroxy-cyclohexyl-phenyl-keton oder Benzophenon handelt.

14. Aushärtbare Masse nach einem der Ansprüche 7 bis 13, **dadurch gekennzeichnet,**
**dass** es sich bei der wenigstens einen zweiten Komponente B um eine Verbindung mit mindestens zwei funktionellen Gruppen, insbesondere um eine Verbindung mit mindestens zwei Amingruppen, handelt.

15. Aushärtbare Masse nach Anspruch 14,
**dadurch gekennzeichnet,**
**dass** sie eine weitere Komponente E enthält, die die Reaktion zwischen der mindestens einen vernetzenden Komponente A und der mindestens einen zweiten Komponente B katalysiert.

16. Aushärtbare Masse nach einem der Ansprüche 7 bis 15,
**dadurch gekennzeichnet,**
**dass** es sich bei der wenigstens einen dritten Komponente C um eine Verbindung mit mindestens zwei funktionellen Gruppen, insbesondere Epoxidfunktionen, handelt.

17. Aushärtbare Masse nach einem der Ansprüche 7 bis 16,
**dadurch gekennzeichnet,**
**dass** ein Mischungsverhältnis zwischen den Komponenten A, B und C so gewählt ist, dass nach Eintritt des ersten und des zweiten Ereignisses in dem mindestens einen ersten Bereich (i) mindestens 99% der Komponenten A, B und C in mindestens eines der sich bildenden Netzwerke eingebaut sind und höchstens 1% funktioneller Gruppen der Komponenten A, B und C verbleiben und dass nach alleinigem Eintritt des zweiten Ereignisses in dem mindestens einen zweiten Bereich (ii) mindestens 99% der Komponenten A, B und C in das zweite Netzwerk (7) eingebaut sind und höchstens 1% funktioneller Gruppen der Komponenten A, B und C verbleiben.

18. Aushärtbare Masse nach einem der Ansprüche 7 bis 17, **dadurch gekennzeichnet,**
**dass** sie mindestens einen Füll- oder Verstärkungsstoff mit einem Anteil zwischen 1 und 99 Gew.-% enthält.

## Claims

1. Method for casting electronic components or component groups, in which
- the component (1) or the component group is embedded in a casting compound (4), which is cured via at least one crosslinking process,
wherein
- a casting compound (4) is used, which contains at least one crosslinking component A, which is homogeneously distributed in the casting compound (4) and can crosslink to form at least two different networks, of which a first network (8) is formed by the at least one crosslinking component A alone, wherein an at least partial crosslinking to form the first network (8) can be triggered by a first event in at least a first region (5) of the casting compound (4),
- contains at least one second component B, which is homogeneously distributed in the casting compound (4) and with which the at least one crosslinking component A can form a second (7) of the at least two different networks, which has a lower crosslink density than the first network (8), wherein the crosslinking to form the second network (7) can be triggered by a second event in at least one second region (6) of the casting compound (4), in which the first network (8) has not been formed, has only been partially formed, and
- contains at least one third component C, which is homogeneously distributed in the casting compound (4) and, after the at least partial crosslinking to form the first network (8), reacts with not yet crosslinked components of the at least one second component B in the first (5) and second region (6) to form a further network, wherein the reaction of the third component C with the second component B is triggered by the second event, and
- the at least one crosslinking component A of the casting compound (4) is at least partially cured to form the first network (8) in at least one region kept at a distance from the first electronic component (1), as a first region (5), or the electronic component group and is cured to form the second network (7) at least in a region enclosing and directly surrounding the electronic component (1) or the electronic component group, as a second region (6) .

2. Method according to Claim 1,
**characterized**
**in that** the at least one crosslinking component A and the at least one second component B are chosen such that the two different networks differ in the modulus of elasticity by at least a factor of 2.

3. Method according to Claim 1 or 2,
**characterized**
**in that** the electronic component (1) or the electronic component group to be cast is introduced into an upwardly open housing (3) and the casting compound (4) is subsequently filled into the housing (3), in order to cast the electronic component (1) or the electronic component group with the casting compound (4), wherein the at least one crosslinking component A of the casting compound (4) is cured at least partially to form the first network (8) in a region containing an upper boundary surface of the casting compound (4), as a first region (5), and is cured to form the second network (7) at least in the remaining region, as a second region (6).

4. Method according to Claim 1 or 2,
**characterized**
**in that** the crosslinking component A is cured to form the first network (8) in a layer of the casting compound (4), as a first region (5), which forms an outer boundary surface of the casting compound (4) and completely encloses the second region (6) with the electronic component (1) or the electronic component group.

5. Method according to Claim 4,
**characterized**
**in that** the casting compound (4) is formed and cured during the casting of the electronic component (1) or the electronic component group such that an outer form of the cured casting compound (4) is approximated to a contour of the electronic component (1) or the electronic component group.

6. Method according to one of Claims 1, 2, 4 or 5,
**characterized**
**in that**, during the casting of the electronic component (1) or the electronic component group, the casting compound (4) is applied and cured layer by layer by an additive manufacturing method.

7. Curable compound, which can be used as a casting compound (4) for the method according to one of the preceding patent claims and which
- contains at least one crosslinking component A, which is homogeneously distributed in the curable compound and can crosslink to form at least two different networks, of which a first network (8) is formed by the at least one crosslinking component A alone, wherein an at least partial crosslinking to form the first network (8) can be triggered by a first event in at least a first region (i) of the curable compound,
- contains at least one second component B, which is homogeneously distributed in the curable compound and with which the at least one crosslinking component A can form a second (7) of the at least two different networks, which has a lower crosslink density than the first network (8), wherein the crosslinking to form the second network (7) can be triggered by a second event in at least one second region (ii) of the curable compound, in which the first network (8) has not been formed, or has only been partially formed, and
- contains at least one third component C, which is homogeneously distributed in the curable compound and, after the at least partial crosslinking to form the first network (8), reacts with not yet crosslinked components of the at least one second component B in the first (i) and second region (ii) to form a further network, wherein the reaction of the third component C with the second component B is triggered by the second event.

8. Curable compound according to Claim 7,
**characterized**
**in that** the crosslinking component A, the second component B and the third component C are chosen such that the first (i) and second region (ii) differ in the modulus of elasticity by at least a factor of 2.

9. Curable compound according to Claim 7 or 8,
**characterized**
**in that** the first event is a treatment with visible or UV light.

10. Curable compound according to one of Claims 7 to 9,
**characterized**
**in that** the second event is a heat treatment.

11. Curable compound according to one of Claims 7 to 10,
**characterized**
**in that** the at least one crosslinking component A is a compound having at least two functional groups, in particular double bonds.

12. Curable compound according to one of Claims 7 to 11,
**characterized**
**in that** it contains at least one further component D, which by irradiation with visible or UV light generates radicals that are capable of crosslinking the at least one crosslinking component A by radical chain reaction.

13. Curable compound according to Claim 12,
**characterized**
**in that** the at least one component D forming radicals by irradiation is bis(2,4,6-trimethylbenzoyl)-phenylphosphine oxide, 1-hydroxycyclohexyl-phenyl-ketone or benzophenone.

14. Curable compound according to one of Claims 7 to 13,
**characterized in that** the at least one second component B is a compound having at least two functional groups, in particular a compound having at least two amine groups.

15. Curable compound according to Claim 14, **characterized in that**
it contains a further component E, which catalyzes the reaction between the at least one crosslinking component A and the at least one second component B.

16. Curable compound according to one of Claims 7 to 15,
**characterized**
**in that** the at least one third component C is a compound having at least two functional groups, in particular epoxide functions.

17. Curable compound according to one of Claims 7 to 16,
**characterized**
**in that** a mixing ratio between the components A, B and C is chosen such that, after the occurrence of the first and the second event, at least 99% of components A, B and C are incorporated in at least one of the forming networks in the at least one first region (i) and at most 1% of functional groups of components A, B and C remain and that, after the sole occurrence of the second event, at least 99% of components A, B and C are incorporated in the second network (7) in the at least one second region (ii) and at most 1% of functional groups of components A, B and C remain.

18. Curable compound according to one of Claims 7 to 17,
**characterized**
**in that** it contains at least one filler or reinforcing agent in a proportion of between 1 and 99% by weight.

## Revendications

1. Procédé d'enrobage de composants électroniques ou de groupes de composants, procédé dans lequel
- le composant (1) ou le groupe de composants est noyé dans une matière d'enrobage (4) qui est durcie par au moins un processus de réticulation,
- une matière d'enrobage (4) étant utilisée, qui contient au moins un composant de réticulation A qui est réparti de manière homogène dans la matière d'enrobage (4) et qui peut se réticuler en au moins deux réseaux différents dont un premier réseau (8) est formé par l'au moins un composant de réticulation A seul, une réticulation au moins partielle en le premier réseau (8) pouvant être déclenchée par un premier événement dans au moins une première zone (5) de la matière d'enrobage (4),
- qui contient au moins un deuxième composant B qui est réparti de manière homogène dans la matière d'enrobage (4) et avec lequel l'au moins un composant de réticulation A peut former un deuxième réseau (7) des au moins deux réseaux différents qui a une densité de réseau inférieure à celle du premier réseau (8), la réticulation en le deuxième réseau (7) pouvant être déclenchée par un deuxième événement dans au moins une deuxième zone (6) de la matière d'enrobage (4) dans laquelle le premier réseau (8) n'a pas été formé ou ne l'a été que partiellement, et
- qui contient au moins un troisième composant C qui est réparti de manière homogène dans la matière d'enrobage (4) et réagit, après la réticulation au moins partielle en le premier réseau (8), avec des portions non encore réticulées de l'au moins un deuxième composant B dans la première zone (5) et dans la deuxième zone (6) pour former un autre réseau, la réaction du troisième composant C avec le deuxième composant B étant déclenchée par le deuxième événement, et
- l'au moins un composant de réticulation A de la matière d'enrobage (4) étant durci au moins partiellement en le premier réseau (8) dans au moins une zone, dite première zone (5), distante du composant électronique (1) ou du groupe de composants électroniques et étant durci en le deuxième réseau (7) au moins dans une zone, dite deuxième zone (6), incluant et entourant directement le composant électronique (1) ou le groupe de composants électroniques.

2. Procédé selon la revendication 1,
**caractérisé en ce que**
l'au moins un composant de réticulation A et l'au moins un deuxième composant B sont choisis de telle sorte que les deux réseaux différents diffèrent d'au moins un facteur 2 en termes de module d'élasticité.

3. Procédé selon la revendication 1 ou 2,
caractérisé en que
le composant électronique (1) ou le groupe de composants électroniques à enrober est introduit dans un boîtier. (3) qui est ouvert vers le haut et la matière d'enrobage (4) vient ensuite remplir le boîtier (3) de manière à ce que le composant électronique (1) ou le groupe de composants électroniques soit enrobé de la matière d'enrobage (4), l'au moins un composant de réticulation A de la matière d'enrobage (4) est durci au moins partiellement en le premier réseau (8) dans une zone, dite première zone (5), comprenant une surface limite supérieure de la matière d'enrobage (4) et en le deuxième réseau (7) au moins dans la zone restante, dite deuxième zone (6).

4. Procédé selon la revendication 1 ou 2,
caractérisé en que
le composant de réticulation A est durci en le premier réseau (8) dans une couche de la matière d'enrobage (4), dite première zone (5), laquelle couche forme une surface limite extérieure de la matière d'enrobage (4) et entoure complètement la deuxième zone (6) comprenant le composant électronique (1) ou le groupe de composants électroniques.

5. Procédé selon la revendication 4,
caractérisé en que
la matière d'enrobage (4) est moulée et durcie pendant l'enrobage du composant électronique (1) ou du groupe de composants électroniques de sorte qu'une forme extérieure de la matière d'enrobage durcie (4) se rapproche d'un contour du composant électronique (1) ou du groupe de composants électroniques.

6. Procédé selon l'une des revendications 1, 2, 4 ou 5,
**caractérisé en ce que**
la matière d'enrobage (4) est appliquée et durcie en couches pendant l'enrobage du composant électronique (1) ou du groupe de composants électroniques à l'aide d'un procédé de fabrication additive.

7. Matière durcissable qui peut être utilisée comme matière d'enrobage (4) dans le procédé selon l'une des revendications précédentes et qui contient
- au moins un composant de réticulation A qui est réparti de manière homogène dans la matière durcissable et qui peut se réticuler en au moins deux réseaux différents dont un premier réseau (8) est formé par l'au moins un composant de réticulation A seul,
une réticulation au moins partielle en le premier réseau (8) pouvant être déclenchée par un premier événement dans au moins une première zone (i) de la matière durcissable,
- au moins un deuxième composant B qui est réparti de manière homogène dans la matière durcissable et avec lequel l'au moins un composant de réticulation A peut former un deuxième réseau (7) des au moins deux réseaux différents qui a une densité de réseau inférieure à celle du premier réseau (8), la réticulation en le deuxième réseau (7) pouvant être déclenchée par un deuxième événement dans au moins une deuxième zone (ii) de la matière durcissable dans laquelle le premier réseau (8) n'a pas été formé ou ne l'a été que partiellement, et
- au moins un troisième composant C qui est réparti de manière homogène dans la matière durcissable et qui réagit, après la réticulation au moins partielle en le premier réseau (8), avec des portions non encore réticulées de l'au moins un deuxième composant B dans la première zone (i) et dans la deuxième zone (ii) pour former un autre réseau, la réaction du troisième composant C avec le deuxième composant B étant déclenchée par le deuxième événement.

8. Matière durcissable selon la revendication 7,
**caractérisée en ce que**
le composant de réticulation A, le deuxième composant B et le troisième composant C sont choisis de telle sorte que la première zone (i) et la deuxième zone (ii) diffèrent d'au moins un facteur 2 en termes de module d'élasticité.

9. Matière durcissable selon la revendication 7 ou 8,
**caractérisée en ce que**
le premier événement est un traitement à la lumière visible ou UV.

10. Matière durcissable selon l'une des revendications 7 à 9,
**caractérisée** en que
le deuxième événement est un traitement thermique.

11. Matière durcissable selon l'une des revendications 7 à 10,
**caractérisée en ce que**
l'au moins un composant de réticulation A est un composé comprenant au moins deux groupes fonctionnels, notamment des doubles liaisons.

12. Matière durcissable selon l'une des revendications 7 à 11,
**caractérisée en ce qu'**elle contient au moins un autre composant D qui génère, par irradiation avec de la lumière visible ou UV, des radicaux qui sont capables de réticuler l'au moins un composant de réticulation A par une réaction en chaîne radicalaire.

13. Matière durcissable selon la revendication 12,
**caractérisée en ce que**
l'au moins un composant D qui forme des radicaux par irradiation est l'oxyde de bis(2,4,6-triméthylbenzoyl)-phénylphosphine, la 1-hydroxy-cyclohexylphényl-cétone ou la benzophénone.

14. Matière durcissable selon l'une des revendications 7 à 13,
**caractérisée en ce que**
l'au moins un deuxième composant B est un composé comprenant au moins deux groupes fonctionnels, en particulier un composé comprenant au moins deux groupes amine.

15. Matière durcissable selon la revendication 14,
**caractérisée en ce**
**qu'**elle contient un autre composant E qui catalyse la réaction entre l'au moins un composant de réticulation A et l'au moins un deuxième composant B.

16. Matière durcissable selon l'une des revendications 7 à 15,
**caractérisée en ce que**
l'au moins un troisième composant C est un composé comprenant au moins deux groupes fonctionnels, en particulier des fonctions époxy.

17. Matière durcissable selon l'une des revendications 7 à 16,
**caractérisée en ce que**
un rapport de mélange entre les composants A, B et C est choisi de telle sorte que, après l'occurrence du premier et du deuxième événement dans l'au moins une première zone (i), au moins 99 % des composants A, B et C soient incorporés dans l'un au moins des réseaux en formation et qu'il ne reste que 1 % au plus des groupes fonctionnels des composants A, B et C et de telle sorte que, après la seul occurrence du deuxième événement dans au moins une deuxième zone (ii), au moins 99 % des composants A, B et C soient incorporés dans le deuxième réseau (7) et qu'il ne reste que 1 % au plus des groupes fonctionnels des composants A, B et C.

18. Matière durcissable selon l'une des revendications 7 à 17,
**caractérisée** en que
elle contient au moins une matière de renforcement ou de remplissage dans une proportion comprise entre 1 et 99 % en poids.
